# EUROPEAN PATENT APPLICATION

(11) **EP 4 694 638 A1**
(43) Date of publication of application: **11.02.2026**
(21) Application number: 24780825.6
(22) Date of filing: 29.03.2024
(51) Int. Cl.: H10K 50/19, H10K 50/12, H10K 59/70, H10K 59/90, H10K 85/30, H10K 85/60, H10K 101/10, H10K 101/40

(54) **ORGANIC EL LIGHTING DEVICE**

(30) Priority: 29.03.2023 JP 2023052959
(71) Applicant: KANEKA CORPORATION, Osaka-shi, Osaka 530-8288 (JP)
(72) Inventor: SAWAKI Yurika, Otsu-shi, Shiga 520-0104 (JP)
(74) Representative: Hoffmann Eitle
(86) International application number: PCT/JP2024/013082
(87) International publication number: WO 2024/204730

(57) **Abstract**

The present invention provides an organic EL lighting device capable of suppressing light emission in a blue region as compared with the related art. An organic EL device including a substrate, an anode, a blue fluorescent light emission unit, a green and red phosphorescent light emission unit, and a cathode is provided, and the organic EL device has a configuration in which a blue fluorescent light emission layer of the blue fluorescent light emission unit includes a phosphorescent material.

## Description

### TECHNICAL FIELD

The present invention relates to an organic EL lighting device.

### BACKGROUND ART

An organic EL lighting device is a semiconductor device that converts electric energy into light energy. Since the organic EL lighting device is thin and emits planarly soft diffused light, it is attracting attention as a light source in place of an incandescent lamp or a fluorescent lamp, and much research has been conducted in recent years.

Toward the widespread adoption of the organic EL lighting device, in addition to improvement in efficiency, luminance, color rendering properties, and device lifetime, there is a growing recent demand for bio-effective functions as well.

For example, as described in Non-Patent Document 1, Brainard et al. reported in 2001 that human melatonin secretion suppression, at either high or minimum illumination, was affected by a blue emission spectrum on a short wavelength side and a spectrum in a 460 nm region on a slightly blue long wavelength side was additionally a factor, and later, Thapan et al. reported that retinal ganglion cells (ipRGCs) having photosensitivity and containing a substance called melanopsin are related to the melatonin secretion suppression.

Furthermore, the relationship of the blue region spectrum as to the human melatonin secretion suppression is described in Non-Patent Document 2 as well.

Patent Document 1 discloses an organic EL element that emits white light having a low color temperature in which light emission in a blue region is suppressed and high color rendering properties with practical power efficiency.

It is described that this organic EL element is suitable as lighting that can contribute to improvement of sleep quality because there is little stimulation to the eye related to melatonin secretion generation in a nighttime living environment.

In this organic EL element, in response to the problem of suppressing light emission in the blue region causing poor power efficiency, the efficiency is improved by making a green and red phosphorescent unit sufficiently separate from a reflective cathode to make it resistant to the influence of the plasmon loss.

Furthermore, a hole transport layer on a blue unit side is used as an adjustment layer so that the blue light emission intensity can be weakened and a distance duv from a black-body radiation curve can be 0.02 or less.

On the other hand, Patent Document 1 does not mention the device lifetime.

### PRIOR ART DOCUMENTS

### PATENT DOCUMENT

Patent Document 1: WO 2022/092131 A

### NON-PATENT DOCUMENTS

Non-Patent Document 1: Hatori & Panda, "The emerging roles of melanopsin in behavioral adaptation to light", Trends in Molecular Medicine, 16-10, pp. 435-446 (2010)
Non-Patent Document 2: Shigekazu Higuchi, "Light and human melatonin suppression", Journal of Chronobiology, vol. 14, no. 1, p. 6-13 (2008)

### DISCLOSURE OF INVENTION

### TECHNICAL PROBLEM

Meanwhile, as a method of suppressing light emission in the blue region in the organic EL element, there are a method of reducing a film thickness of the blue region and a method of reducing a content of a blue luminescent material. However, in these methods, there is a problem that the lifetime of the blue region is also reduced.

Therefore, an object of the present invention is to provide an organic EL lighting device capable of suppressing light emission in a blue region as compared with the related art.

### SOLUTION TO PROBLEM

One aspect of the present invention for solving the above problems is an organic EL lighting device including an organic EL device including a substrate, an anode, a blue fluorescent light emission unit, a green and red phosphorescent light emission unit, and a cathode, in which in the organic EL device, a blue fluorescent light emission layer of the blue fluorescent light emission unit includes at least a fluorescent light emission host material and a phosphorescent material.

According to this aspect, energy transfer from the phosphorescent material in a triplet excited state generated in the blue fluorescent light emission layer to the fluorescent light emission host material occurs, a part of the fluorescent light emission host material becomes a pseudo triplet excited state, and the part of the fluorescent light emission host material is non-radiation deactivated. Therefore, the blue light intensity of the blue fluorescent light emission layer of the blue fluorescent light emission unit decreases as compared with the case where the phosphorescent material is not added, and a decrease in device lifetime can also be suppressed.

In a preferred aspect, the phosphorescent material has a maximum light emission wavelength of 450 nm to 650 nm.

According to this aspect, it is possible to suppress a decrease in device lifetime while lowering the intensity of blue light of the organic EL device.

In a preferred aspect, an amount of the phosphorescent material in the blue fluorescent light emission layer is 0.3 wt% or more.

According to this aspect, it is possible to suppress a decrease in device lifetime while sufficiently lowering the intensity of blue light of the organic EL device.

In a preferred aspect, a charge generating layer between the blue fluorescent light emission unit and the green and red phosphorescent light emission unit is included, and an amount of the phosphorescent material in the blue fluorescent light emission layer is 0.1 wt% or more and less than 0.3 wt%.

According to this aspect, since the ratio which the deactivation process is generated changes as a result of the changing of the content of the phosphorescent material, the blue light intensity can be controlled without changing the film thickness.

In a preferred aspect, white light having a Melanopic Ratio value of 0.5 or less is emitted, and the white light has a color temperature of 2000 K to 3000 K, a duv from a black-body radiation curve of 0.02 or less, and color reproducibility of 80 or more.

According to this aspect, the load for visual recognition of objects, including colors, is reduced, gentle on the eyes in a nighttime residential setting, and the eyes are less stimulated with respect to melatonin secretion generation. Therefore, it is possible to contribute to improvement of sleep quality.

In a preferred aspect, an energy level of a triplet excited state of the fluorescent light emission host material of the blue fluorescent light emission layer is deeper than an energy level of a triplet excited state of the phosphorescent material.

In a preferred aspect, the organic EL device; and a blue light source are included, and the blue light source is capable of emitting blue light that complements irradiation light of the organic EL device.

In a preferred aspect, the blue light source includes a blue OLED or a blue LED.

According to these aspects, color adjustment at a high color temperature becomes possible.

### EFFECT OF INVENTION

According to the organic EL lighting device of the present invention, it is possible to suppress a decrease in device lifetime while lowering the intensity of blue light.

### BRIEF DESCRIPTION OF DRAWINGS

Fig. 1 is a cross-sectional view of a main part of an organic EL lighting device according to a first embodiment of the present invention, and hatching is omitted for easy understanding.
Fig. 2 is a total light flux spectrum of an organic EL lighting device of Example 1.
Fig. 3 illustrates a change in blue light peak intensity at the time of heating and applying current of the organic EL lighting device of Example 1.
Fig. 4 illustrates a change in correlated color temperature at the time of heating and applying current of the organic EL lighting device of Example 1.
Fig. 5 is a total light flux spectrum of an organic EL lighting device of Example 2.
Fig. 6 illustrates a change in blue light peak intensity at the time of heating and applying current of the organic EL lighting device of Example 2.
Fig. 7 illustrates a change in correlated color temperature at the time of heating and applying current of the organic EL lighting device of Example 2.
Fig. 8 is a total light flux spectrum of an organic EL lighting device of Example 3.
Fig. 9 illustrates a change in blue light peak intensity at the time of heating and applying current of the organic EL lighting device of Example 3.
Fig. 10 illustrates a change in correlated color temperature at the time of heating and applying current of the organic EL lighting device of Example 3.
Fig. 11 is a total light flux spectrum of an organic EL lighting device of Example 4.
Fig. 12 is a total light flux spectrum of an organic EL lighting device of Example 5.
Fig. 13 is a total light flux spectrum of an organic EL lighting device of Example 6.
Fig. 14 is a total light flux spectrum of an organic EL lighting device of Example 7.
Fig. 15 is a total light flux spectrum of an organic EL lighting device of Comparative Example 1.
Fig. 16 illustrates a change in blue light peak intensity at the time of heating and applying current of the organic EL lighting device of Comparative Example 1.
Fig. 17 illustrates a change in correlated color temperature at the time of heating and applying current of the organic EL lighting device of Comparative Example 1.
Fig. 18 is a cross-sectional configuration diagram of organic EL lighting devices of Examples 1 to 7 and Comparative Example 1.

### BEST MODE FOR CARRYING OUT THE INVENTION

Hereinafter, embodiments of the present invention will be described in detail.

### (Organic EL lighting device 10)

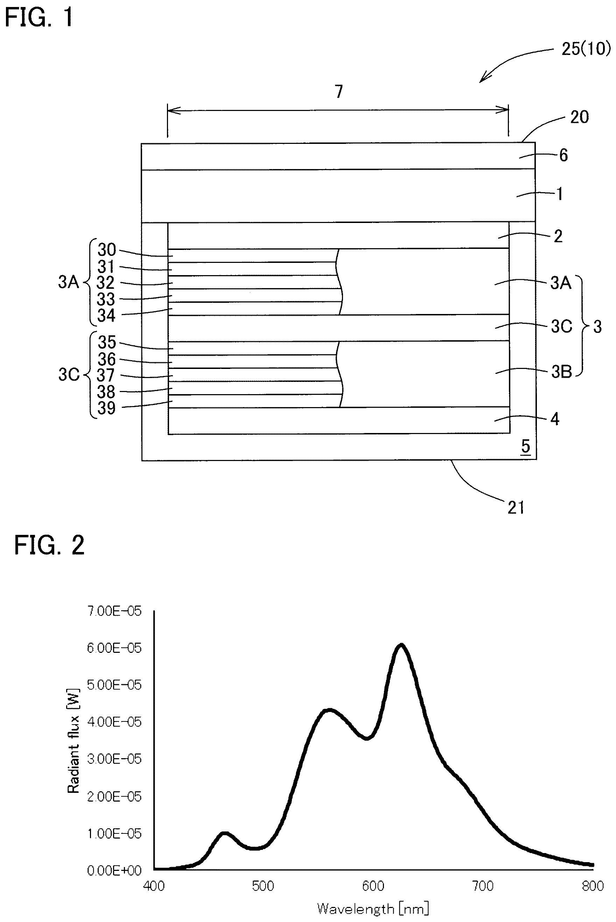

As illustrated in Fig. 1, an organic EL lighting device 10 according to a first embodiment of the present invention includes an organic EL device 25 having a light exit surface 20 and a back surface 21 as both main surfaces and emitting white light from a light emitting region 7 on a side of the light exit surface 20.

The organic EL device 25 is a member having a planar expansion, and is preferably a plate-like member.

The organic EL device 25 preferably includes a sealing layer 5 that covers an entire surface of the light emitting region 7 on a side of the back surface 21 thereof in plan view as can be seen from Fig. 1 from the viewpoint of suppressing occurrence of dark spots (DS) and device lifetime shortening.

As illustrated in Fig. 1, the organic EL device 25 includes a substrate 1, an anode 2, a light-emitting functional layer 3, and a cathode 4 in this order from the side of the light exit surface 20 toward a side of the back surface 21, and these overlapping portions coincide with the light emitting region 7 in plan view.

It is preferable that the light-emitting functional layer 3 includes at least a blue fluorescent light emission unit 3A and a green and red phosphorescent light emission unit 3B in this order from a side of the substrate 1, and includes a charge generating layer 3C between the blue fluorescent light emission unit 3A and the green and red phosphorescent light emission unit 3B as illustrated in Fig. 1.

The light-emitting functional layer 3 is mainly formed of organic compounds, and known materials such as low-molecular-weight dye materials or conjugated polymer materials generally used in an organic EL device can be used.

The light-emitting functional layer 3 can be appropriately formed by a known method such as a vacuum vapor deposition method, a sputtering method, a CVD method, or various coating methods, and from the viewpoint of making a high-performance device, it is preferably formed by a vacuum vapor deposition method.

The white light emitted from the light exit surface 20 of the organic EL device 25 preferably has a Melanopic Ratio value of 0.5 or less as an index related to melatonin secretion suppression.

The white light emitted from the light exit surface 20 of the organic EL device 25 preferably has a color temperature of 2000 K to 3000 K.

In the white light emitted from the light exit surface 20 of the organic EL device 25, the coordinate duv in the CIE1931 chromaticity coordinate system is preferably at a distance of 0.02 or less from the black-body radiation curve.

The white light emitted from the light exit surface 20 of the organic EL device 25 preferably has an Ra value related to color reproducibility, that is, an average color rendering index Ra of 80 or more.

The organic EL lighting device 10 can also use a blue light source including a blue OLED or a blue LED in addition to the organic EL device 25.

That is, the organic EL lighting device 10 may include a blue light source separately from the organic EL device 25, and the organic EL device 25 and the blue light source may be arranged on the same plane.

In this case, the blue light source is preferably capable of emitting blue light that complements white light which is irradiation light of the organic EL device 25.

### (Substrate 1)

The substrate 1 is a member having a planar expanse and made of a translucent material.

The substrate 1 can be, for example, a glass substrate or a resin film substrate, and is preferably a glass substrate from the viewpoint of suppressing moisture ingress into the organic EL lighting device 10 that causes performance deterioration.

Furthermore, the substrate 1 can also be a flexible substrate.

### (Anode 2)

As a material of the anode 2, a transparent conductive metal oxide such as indium tin oxide (ITO), indium zinc oxide (IZO), tin oxide (SnO₂), or zinc oxide (ZnO) can be employed, and from the viewpoint of providing a high-performance device, highly transparent ITO or IZO is preferable.

### (Blue fluorescent light emission unit 3A)

The blue fluorescent light emission unit 3A includes a blue fluorescent light emission layer 32 that emits blue light, and has a hole transporting surface and an electron transporting surface as both surfaces.

As illustrated in Fig. 1, the blue fluorescent light emission unit 3A preferably includes a hole injection layer 30, a hole transport layer 31, a blue fluorescent light emission layer 32, an electron transport layer 33, and an electron injection layer 34 in this order from a side of the anode 2.

### (Charge generating layer 3C)

The charge generating layer 3C has a function of connecting the blue fluorescent light emission unit 3A and the green and red phosphorescent light emission unit 3B.

Specifically, the charge generating layer 3C has a function of injecting electrons to a side of the blue fluorescent light emission unit 3A and injecting holes to a side of the green and red phosphorescent light emission unit 3B when the organic EL lighting device 10 is applied current.

### (Green and red phosphorescent light emission unit 3B)

The green and red phosphorescent light emission unit 3B includes a green and red phosphorescent mixed light emission layer 37 that emits green light and red light, and has a hole transporting surface and an electron transporting surface as both surfaces.

The green and red phosphorescent mixed light emission layer 37 includes a green color phosphorescent material, a red color phosphorescent material, and a phosphorescent light emission host material.

As illustrated in Fig. 1, the green and red phosphorescent light emission unit 3B preferably includes a hole injection layer 35, a hole transport layer 36, the green and red phosphorescent mixed light emission layer 37, an electron transport layer 38, and an electron injection layer 39 in this order from the side of the anode 2 (side of the charge generating layer 3C).

### (Hole injection layers 30 and 35)

The hole injection layer 30 is, for example, a layer that takes in holes from the anode 2 and injects the holes into the hole transport layer 31.

The hole injection layer 35 is, for example, a layer that takes in holes from the charge generating layer 3C and injects the holes into the hole transport layer 36.

Furthermore, as the hole injection layers 30 and 35, a hole transporting material doped with an electron-accepting dopant can also be preferably employed from the viewpoint of improving the luminance by improving the transparency of the hole injection layers 30 and 35.

The hole injection layers 30 and 35 preferably have an average thickness of 0.1 nm or more and 20 nm or less.

### (Hole transporting material)

As the hole transporting material, for example, a triphenylamine-based compound, a carbazole-based compound, or the like can be employed.

### (Electron-accepting dopant)

As the electron-accepting dopant, a tetracyanoquinodimethane-based compound, molybdenum oxide (MoO₃), tungsten oxide (WO₃), vanadium oxide (V₂O₅), and the like can be employed.

### (Hole transport layers 31 and 36)

The hole transport layer 31 is a layer that restricts movement of electrons to the side of the anode 2 while efficiently transporting holes from the side of the hole injection layer 30 to the blue fluorescent light emission layer 32.

The hole transport layer 36 is a layer that restricts movement of electrons to the side of the charge generating layer 3C (side of the anode 2) while efficiently transporting holes from the side of the hole injection layer 35 to the green and red phosphorescent mixed light emission layer 37.

As a material of the hole transport layers 31 and 36, a known hole transporting material can be used.

The hole transport layers 31 and 36 preferably have an average thickness of 1 nm or more and 200 nm or less.

### (Blue fluorescent light emission layer 32)

The blue fluorescent light emission layer 32 contains a blue fluorescent light-emitting material, a phosphorescent material, and a fluorescent light emission host material, and the fluorescent light emission host material is an electron transporting host material.

The thickness of the blue fluorescent light emission layer 32 is preferably 1 nm or more and 40 nm or less, and more preferably has an emission peak at 470 nm or less.

An energy level of a triplet excited state of the fluorescent light emission host material of the blue fluorescent light emission layer 32 is preferably deeper than an energy level of a triplet excited state of the phosphorescent material from the viewpoint of efficiently bringing a part of the fluorescent light emission host material into a pseudo triplet excited state.

### (Blue fluorescent light-emitting material)

As the blue fluorescent light-emitting material, perylene 4,4'-bis (9-ethyl-3-carbazovinylene)-1,1-biphenyl (BCzVBi), 4,4'-bis [4-(di-p-triamino) styryl] biphenyl (DPAVBi), or the like can be adopted.

### (Phosphorescent material)

The phosphorescent material preferably has a maximum light emission wavelength of 450 nm to 650 nm.

An addition amount of the phosphorescent material in the blue fluorescent light emission layer 32 is not particularly limited, but is preferably 0.1 wt% or more, more preferably 0.2 wt% or more, still more preferably 0.3 wt% or more, and particularly preferably 0.5 wt% or more from the viewpoint of suppressing light emission in a blue region.

The addition amount of the phosphorescent material in the blue fluorescent light emission layer 32 is preferably 1 wt% or less, more preferably 0.7 wt% or less, and still more preferably 0.6 wt% or less from the viewpoint of maintaining sufficient light emission in the blue region, and
the addition amount of the phosphorescent material in the blue fluorescent light emission layer 32 is preferably less than 0.6 wt% and preferably 0.1 wt% or more and less than 0.3 wt% from the viewpoint of obtaining a good average color rendering index Ra.

As the red-based color phosphorescent material, (bzq)₂Ir(acac), (btp)₂Ir(acac), Ir(bzq)₃, Ir(piq)₃, and the like, which are iridium complexes, can be employed.

As the green-based color phosphorescent material, (ppy)₂Ir(acac), Ir(ppy)₃, and the like, which are iridium complexes, can be employed.

As the blue-based color phosphorescent material, FIrpic, FIr6, Ir(Fppy)₃, and the like, which are iridium complexes, can be employed.

### (Electron transport layers 33 and 38)

The electron transport layer 33 is a layer that restricts the movement of electrons to the side of the cathode 4 (side of the charge generating layer 3C) while efficiently transporting electrons from the side of the electron injection layer 34 to the blue fluorescent light emission layer 32.

The electron transport layer 38 is a layer that restricts the movement of electrons to the side of the cathode 4 while efficiently transporting electrons from the side of the electron injection layer 39 to the green and red phosphorescent mixed light emission layer 37.

As a material of the electron transport layers 33 and 38, a known electron transporting material can be used.

The electron transport layers 33 and 38 preferably have an average thickness of 1 nm or more and 200 nm or less.

### (Electron injection layers 34 and 39)

The electron injection layer 34 is, for example, a layer that takes in electrons from the charge generating layer 3C and injects the electrons into the electron transport layer 33.

The electron injection layer 39 is, for example, a layer that takes in electrons from the cathode 4 and injects the electrons into the electron transport layer 38.

For the electron injection layers 34 and 39, from the viewpoint of improving the luminance by improving the transparency of the electron injection layers 34 and 39, an electron transporting material doped with an electron-donating dopant can also be preferably employed.

The electron injection layers 34 and 39 preferably have an average thickness of 0.1 nm or more and 20 nm or less.

### (Electron transporting material)

Examples of the electron transporting material include a quinolinolato-based metal complex, an anthracene-based compound, an oxadiazole-based compound, a triazole-based compound, a phenanthroline-based compound, and a silol-based compound.

### (Electron-donating dopant)

As the electron-donating dopant, an alkali metal, an alkaline earth metal, a rare earth metal, a compound of these metals, a phthalocyanine complex having these metals as a central metal, a dihydroimidazole compound, or the like can be employed.

### (Cathode 4)

The cathode 4 can be formed using various metal materials, and among them, a white glossy metal is preferable, and among them, silver (Ag) or aluminum (Al) is more preferable.

### (Out-coupling layer)

In order to improve the angle-dependent optical characteristics of luminance and color of the organic EL lighting device 10, as illustrated in Fig. 1, it is preferable that an out-coupling layer 6 (OCL) is provided on an outermost surface of a region including at least the light emitting region 7 on the side of the light exit surface 20.

### EXAMPLES

Hereinafter, the present invention will be specifically described with reference to Examples and Comparative Examples.

Note that the present invention is not limited to the following examples, and can be appropriately modified without changing the gist.

### (Example 1)

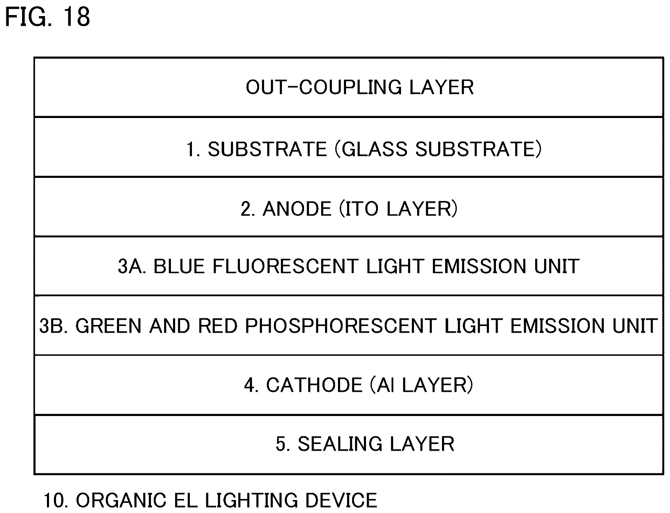

In Example 1, an organic EL lighting device of a cross-sectional configuration diagram of Fig. 18 was produced.

Specifically, an indium tin oxide (ITO) layer was formed as the anode 2 on the device formation surface of the glass substrate as the substrate 1. Next, the blue fluorescent light emission unit 3A, the charge generating layer, the green and red phosphorescent light emission unit 3B, and an aluminum (Al) layer as the cathode 4 were formed in this order on the ITO layer, thereby preparing a two-stage stacked device of the anode 2/blue fluorescent light emission unit 3A/charge generating layer/green and red phosphorescent light emission unit 3B/cathode 4.

Here, the blue fluorescent light emission layer of the blue fluorescent light emission unit 3A contains a fluorescent light emission host material, a blue fluorescent light-emitting material, and a phosphorescent material having a maximum light emission wavelength of 600 nm to 650 nm, and the phosphorescent material contains 0.6 wt% with respect to the total mass of the fluorescent light emission host material and the blue fluorescent light-emitting material.

### (Example 2)

The organic EL lighting device of Example 2 was performed in a similar manner to Example 1 except that the maximum light emission wavelength of the phosphorescent material contained in the blue fluorescent light emission layer was 500 nm to 600 nm.

### (Example 3)

The organic EL lighting device of Example 3 was performed in a similar manner to Example 1 except that the maximum light emission wavelength of the phosphorescent material contained in the blue fluorescent light emission layer was 450 nm to 500 nm.

### (Example 4)

The organic EL lighting device of Example 4 was performed in a similar manner to Example 1 except that the addition amount of the phosphorescent material contained in the blue fluorescent light emission layer was 0.3 wt% with respect to the combined mass of the fluorescent light emission host material and the blue fluorescent light-emitting material.

### (Example 5)

The organic EL lighting device of Example 5 was performed in a similar manner to Example 1 except that the addition amount of the phosphorescent material contained in the blue fluorescent light emission layer was 0.2 wt% with respect to the combined mass of the fluorescent light emission host material and the blue fluorescent light-emitting material.

### (Example 6)

The organic EL lighting device of Example 6 was performed in a similar manner to Example 1 except that the maximum light emission wavelength of the phosphorescent material contained in the blue fluorescent light emission layer was 450 nm to 500 nm, and the added amount of the phosphorescent material was 0.3 wt% with respect to the combined mass of the fluorescent light emission host material and the blue fluorescent light-emitting material.

### (Example 7)

The organic EL lighting device of Example 7 was performed in a similar manner to Example 1 except that the maximum light emission wavelength of the phosphorescent material contained in the blue fluorescent light emission layer was 450 nm to 500 nm, and the added amount of the phosphorescent material was 0.2 wt% with respect to the combined mass of the fluorescent light emission host material and the blue fluorescent light-emitting material.

### (Comparative Example 1)

The organic EL lighting device of Comparative Example 1 was performed in a similar manner to Example 1 except that the blue fluorescent light emission layer of the blue fluorescent light emission unit 3A did not contain a phosphorescent material.

### (Evaluation of total light flux spectrum)

The total light flux spectrum was measured by lighting at a current density of 3 mA/cm² according to JIS C 7801 using a total light flux measurement system (φ 12inch HM manufactured by OTSUKAELECTRONICS).

### (Evaluation of TCP)

In accordance with JIS Z 8725, measurement was performed by the total light flux measurement system with lighting at a current density of 3 mA/cm², and a correlated color temperature TCP was calculated.

### (Evaluation of duv)

In accordance with JIS Z 8725, the measurement was performed by the total light flux measurement system with lighting at a current density of 3 mA/cm², and a distance duv from the black-body radiation curve was calculated.

### (Evaluation of Ra)

In accordance with JIS Z 8726, the total light flux measurement system was used to measure the color rendering properties Ra by lighting at a current density of 3 mA/cm².

### (Evaluation of Melanopic Ratio value)

The total light flux spectrum was measured by the total light flux measurement system with lighting at a current density of 3 mA/cm², and a Melanopic Ratio value was simulated using Tool Box (https://resources.wellcertified.com/tools/well-building-standard-v2/) published by The WELL Building Standard.

### (Evaluation of blue light peak intensity)

Using a spectroradiometer (CS-2000 manufactured by KONICA MINOLTA, INC.), a radiation spectrum was measured while lighting at a current density of 3 mA/cm², and the relative emission intensity of the emission peak observed in the region of 430 nm to 490 nm was evaluated.

Table 1 shows wavelengths and added concentrations of the phosphorescent materials, measured TCP (K), duv, Ra, Melanopic Ratio value, and blue light peak intensity (%) of Examples 1 to 7 and Comparative Example 1.

### [Table 1]

**TABLE 1**

| | Phosphorescent material wavelength (nm) | Phosphorescent material addition concentration (wt%) | TCP (K) | duv | Ra | Melanopic Ratio value | Blue light peak intensity (%) |
|---|---|---|---|---|---|---|---|
| Example 1 | 600-650 | 0.6 | 2702 | 0.012 | 81 | 0.335 | 18 |
| Example 2 | 500-600 | 0.6 | 2797 | 0.009 | 83 | 0.384 | 24 |
| Example 3 | 450-500 | 0.6 | 2827 | 0.009 | 84 | 0.401 | 28 |
| Example 4 | 600-650 | 0.3 | 2959 | 0.009 | 84 | 0.439 | 35 |
| Example 5 | 600-650 | 0.2 | 3127 | 0.006 | 86 | 0.512 | 47 |
| Example 6 | 450-500 | 0.3 | 3109 | 0.006 | 86 | 0.509 | 47 |
| Example 7 | 450-500 | 0.2 | 3224 | 0.003 | 90 | 0.579 | 58 |
| Com parative Example 1 | No addition | No addition | 3753 | -0.004 | 93 | 0.784 | 100 |

### [Table 2]

**TABLE 2**

| | Rate of change in blue light peak intensity due to heating and applying current for 300 hours (%) | Rate of change in correlated color temperature due to heating and applying current for 300 hours (K) |
|---|---|---|
| Example 1 | 11 | 41 |
| Example 2 | 13 | 14 |
| Example 3 | 16 | 29 |
| Comparative Example 1 | 26 | -338 |

Fig. 2 is a total light flux spectrum when the organic EL lighting device of Example 1 is lit at a current density of 3 mA/cm².

The correlated color temperature TCP of the organic EL lighting device of Example 1 calculated from the spectrum in Fig. 2 was 2702 K, the deviation duv from the black-body radiation was 0.012, the color reproducibility Ra was 81, and the Melanopic Ratio value was 0.335.

Assuming that the blue light peak intensity of the organic EL lighting device of Comparative Example 1 described later was 100%, the blue light peak intensity of the organic EL lighting device of Example 1 was 18%.

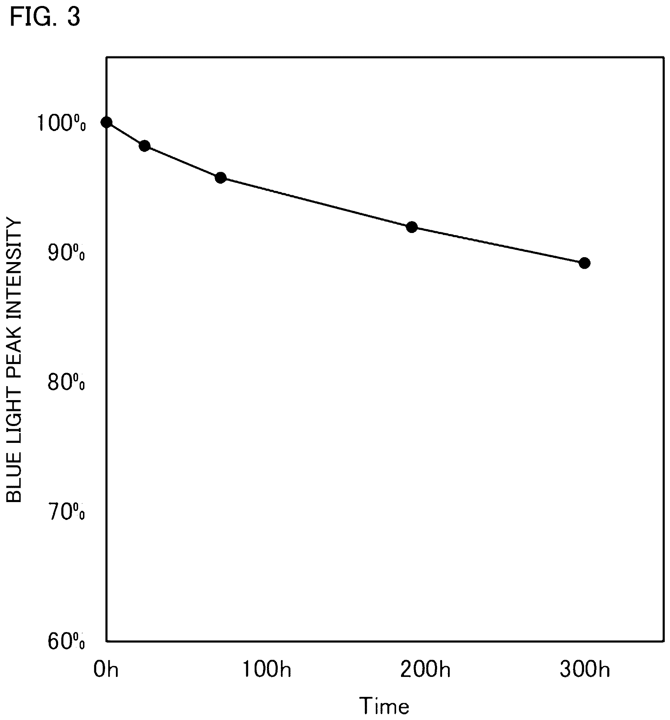

Fig. 3 illustrates a change in blue light peak intensity when heating and applying current were performed at 85°C and a current density of 10 mA/cm² in the organic EL lighting device of Example 1.

Assuming that the blue light peak intensity before the start of heating and applying current of the organic EL lighting device of Example 1 was 100%, the blue light peak intensity after heating and applying current for 300 hours was 89%, and a rate of change in blue light peak intensity was 11%.

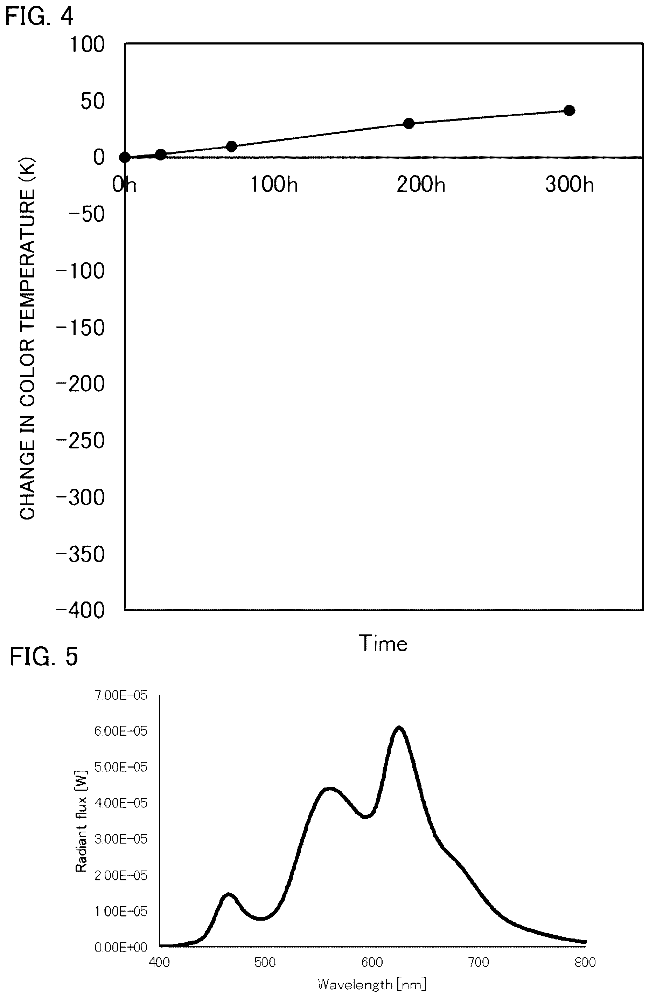

Fig. 4 illustrates a change in correlated color temperature when heating and applying current are performed at 85°C and a current density of 10 mA/cm² in the organic EL lighting device of Example 1.

The change in correlated color temperature of the organic EL lighting device of Example 1 from before the start of heating and applying current to after heating and applying current for 300 hours was 41 K.

Fig. 5 is a total light flux spectrum when the organic EL lighting device of Example 2 is lit at a current density of 3 mA/cm².

Similarly to Example 1, as a result of calculation from the total light flux spectrum of the organic EL lighting device of Example 2, the correlated color temperature TCP was 2797 K, the duv was 0.009, the Ra was 83, and the Melanopic Ratio value was 0.384.

Assuming that the blue light peak intensity of the organic EL lighting device of Comparative Example 1 was 100%, the blue light peak intensity of the organic EL lighting device of Example 2 was 24%.

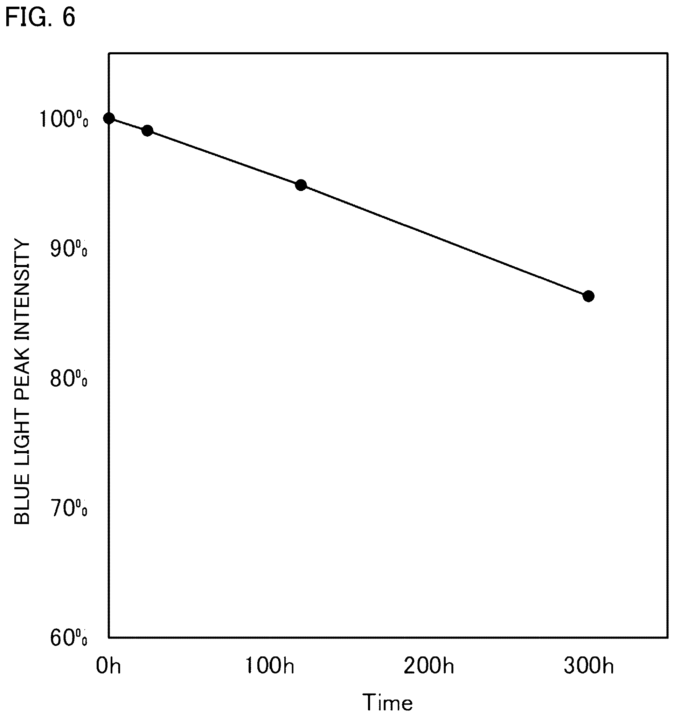

Fig. 6 illustrates a change in blue light peak intensity when heating and applying current were performed at 85°C and a current density of 10 mA/cm² in the organic EL lighting device of Example 2.

Assuming that the blue light peak intensity before the start of heating and applying current of the organic EL lighting device of Example 2 was 100%, the blue light peak intensity after heating and applying current for 300 hours was 87%, and a rate of change in blue light peak intensity was 13%.

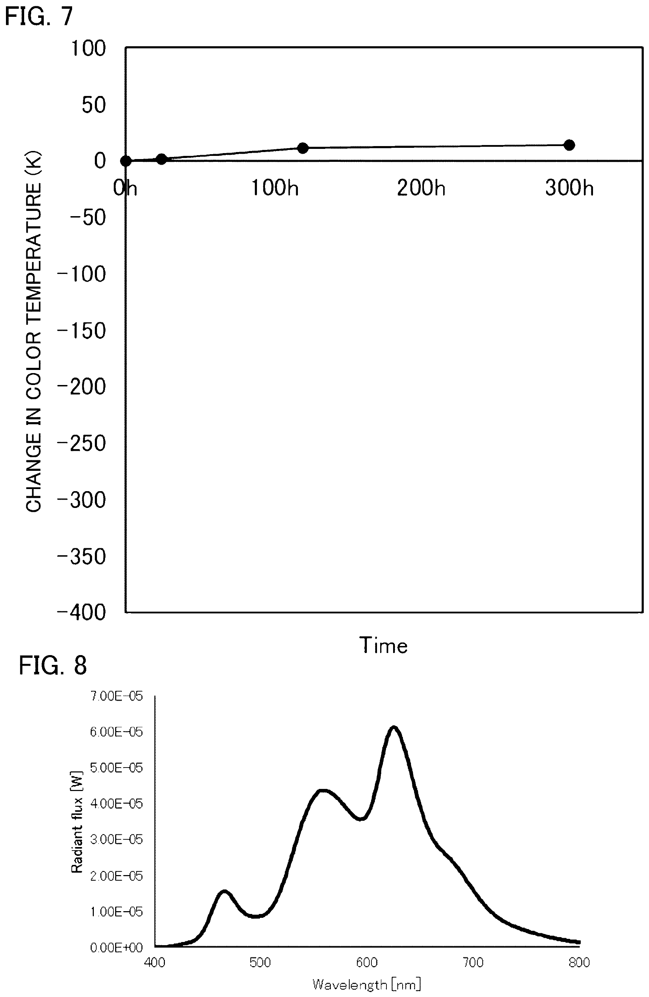

Fig. 7 illustrates a change in correlated color temperature when heating and applying current are performed at 85°C and a current density of 10 mA/cm² in the organic EL lighting device of Example 2.

The change in correlated color temperature of the organic EL lighting device of Example 2 from before the start of heating and applying current to after heating and applying current for 300 hours was 14 K.

Fig. 8 is a total light flux spectrum when the organic EL lighting device of Example 3 is lit at a current density of 3 mA/cm².

Similarly to Example 1, as a result of calculation from the total light flux spectrum of the organic EL lighting device of Example 3, the correlated color temperature TCP was 2827 K, the duv was 0.009, the Ra was 84, and the Melanopic Ratio value was 0.401.

Assuming that the blue light peak intensity of the organic EL lighting device of Comparative Example 1 was 100%, the blue light peak intensity of the organic EL lighting device of Example 3 was 28%.

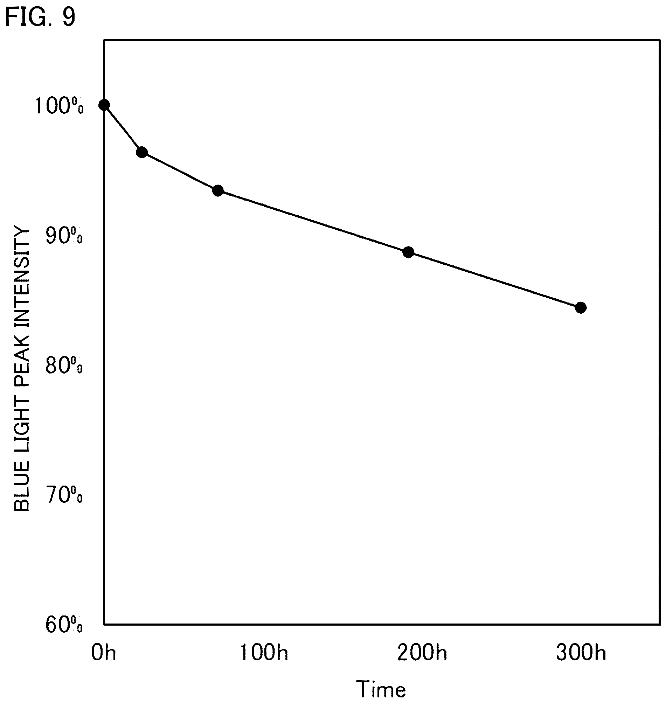

Fig. 9 illustrates a change in blue light peak intensity when heating and applying current were performed at 85°C and a current density of 10 mA/cm² in the organic EL lighting device of Example 3.

Assuming that the blue light peak intensity before the start of heating and applying current of the organic EL lighting device of Example 3 was 100%, the blue light peak intensity after heating and applying current for 300 hours was 84%, and a rate of change in blue light peak intensity was 16%.

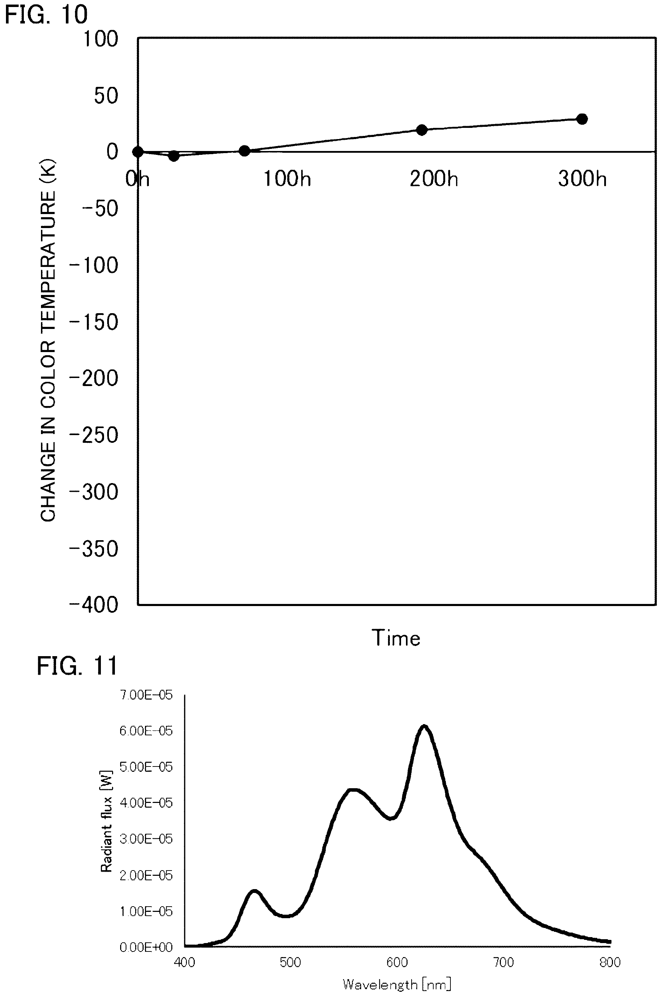

Fig. 10 illustrates a change in correlated color temperature when heating and applying current are performed at 85°C and a current density of 10 mA/cm² in the organic EL lighting device of Example 3.

The change in correlated color temperature of the organic EL lighting device of Example 3 from before the start of heating and applying current to after heating and applying current for 300 hours was 29 K.

Fig. 11 is a total light flux spectrum when the organic EL lighting device of Example 4 is lit at a current density of 3 mA/cm².

Similarly to Example 1, as a result of calculation from the total light flux spectrum of the organic EL lighting device of Example 4, the correlated color temperature TCP was 2959 K, the duv was 0.009, the Ra was 84, and the Melanopic Ratio value was 0.439.

Assuming that the blue light peak intensity of the organic EL lighting device of Comparative Example 1 was 100%, the blue light peak intensity of the organic EL lighting device of Example 4 was 35%.

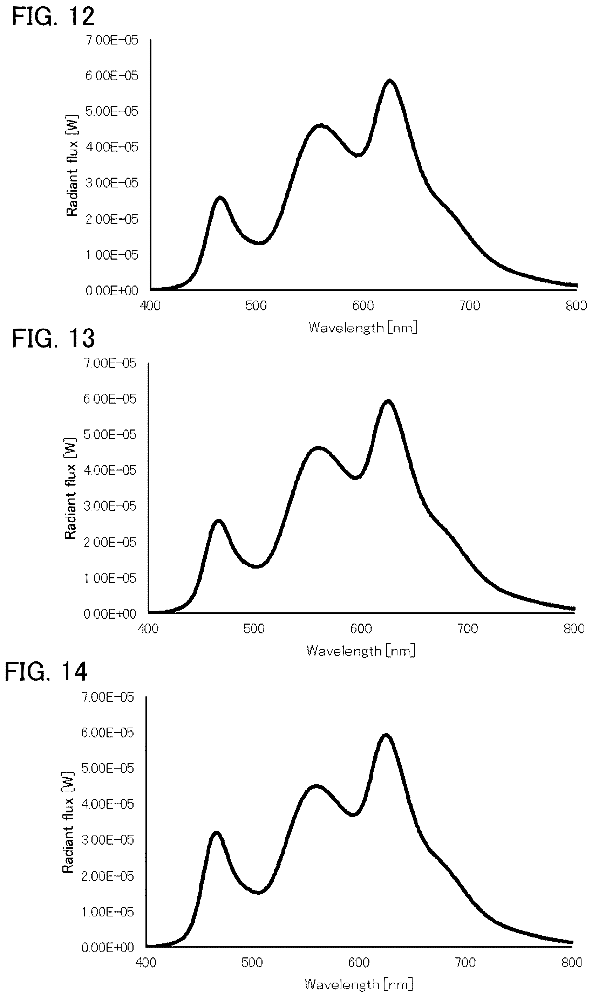

Fig. 12 is a total light flux spectrum when the organic EL lighting device of Example 5 is lit at a current density of 3 mA/cm².

Similarly to Example 1, as a result of calculation from the total light flux spectrum of the organic EL lighting device of Example 5, the correlated color temperature TCP was 3127 K, the duv was 0.006, the Ra was 86, and the Melanopic Ratio value was 0.512.

Assuming that the blue light peak intensity of the organic EL lighting device of Comparative Example 1 was 100%, the blue light peak intensity of the organic EL lighting device of Example 5 was 47%.

Fig. 13 is a total light flux spectrum when the organic EL lighting device of Example 6 is lit at a current density of 3 mA/cm².

Similarly to Example 1, as a result of calculation from the total light flux spectrum of the organic EL lighting device of Example 6, the correlated color temperature TCP was 3109 K, the duv was 0.006, the Ra was 86, and the Melanopic Ratio value was 0.509.

Assuming that the blue light peak intensity of the organic EL lighting device of Comparative Example 1 was 100%, the blue light peak intensity of the organic EL lighting device of Example 6 was 47%.

Fig. 14 is a total light flux spectrum when the organic EL lighting device of Example 7 is lit at a current density of 3 mA/cm².

Similarly to Example 1, as a result of calculation from the total light flux spectrum of the organic EL lighting device of Example 7, the correlated color temperature TCP was 3224 K, the duv was 0.003, the Ra was 90, and the Melanopic Ratio value was 0.579.

Assuming that the blue light peak intensity of the organic EL lighting device of Comparative Example 1 was 100%, the blue light peak intensity of the organic EL lighting device of Example 7 was 58%.

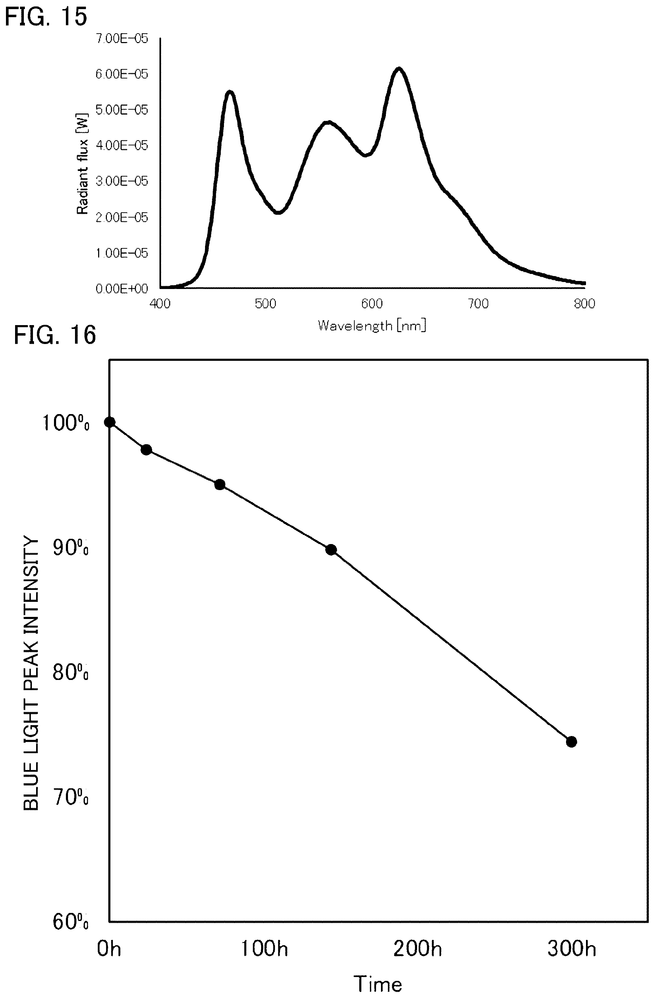

Fig. 15 is a total light flux spectrum when the organic EL lighting device of Comparative Example 1 is lit at a current density of 3 mA/cm².

Similarly to Example 1, as a result of calculation from the total light flux spectrum of the organic EL lighting device of Comparative Example 1, the correlated color temperature TCP was 3753 K, the duv was -0.004, the Ra was 93, and the Melanopic Ratio value was 0.784.

Fig. 16 illustrates a change in blue light peak intensity when heating and applying current were performed at 85°C and a current density of 10 mA/cm² in the organic EL lighting device of Comparative Example 1.

Assuming that the blue light peak intensity before the start of heating and applying current of the organic EL lighting device of Comparative Example 1 was 100%, the blue light peak intensity after heating and applying current for 300 hours was 74%, and a rate of change in blue light peak intensity was 26%.

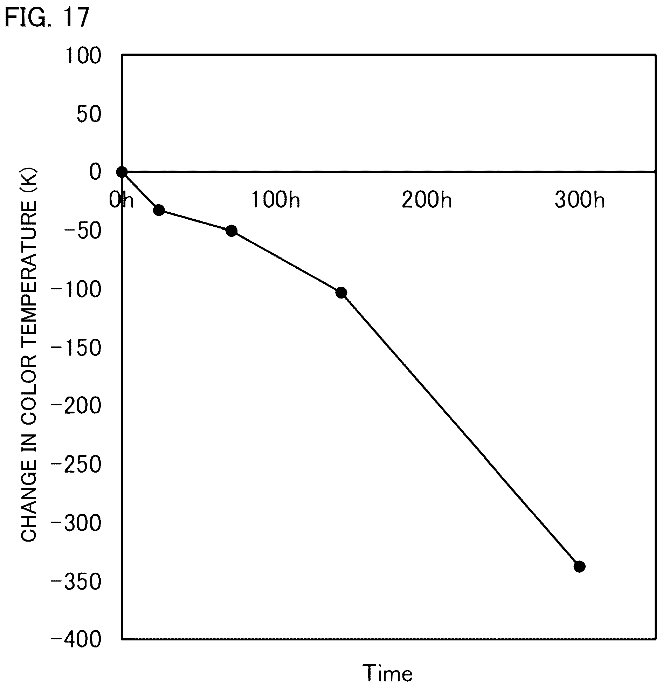

Fig. 17 illustrates a change in color temperature when heating and applying current are performed at 85°C and a current density of 10 mA/cm² in the organic EL lighting device of Comparative Example 1.

The change in correlated color temperature of the organic EL lighting device of Comparative Example 1 from before the start of heating and applying current to after heating and applying current for 300 hours was -338 K.

The following can be seen from Table 1 and Fig. 2 (total light flux spectrum of Example 1), Fig. 5 (total light flux spectrum of Example 2), Fig. 8 (total light flux spectrum of Example 3), and Fig. 15 (total light flux spectrum of Comparative Example 1).

By adding 0.6 wt% of a phosphorescent material having a maximum light emission wavelength of 450 nm to 650 nm to the blue fluorescent light emission layer of the blue fluorescent light emission unit 3A, the blue light peak intensity around a wavelength of 460 nm can be sufficiently suppressed.

The following can be seen from Table 2 and Fig. 3 (change in blue light peak intensity at the time of heating and applying current in Example 1), Fig. 6 (change in blue light peak intensity at the time of heating and applying current in Example 2), Fig. 9 (change in blue light peak intensity at the time of heating and applying current in Example 3), and Fig. 16 (change in blue light peak intensity at the time of heating and applying current in Comparative Example 1).

By adding 0.6 wt% of a phosphorescent material having a maximum light emission wavelength of 450 nm to 650 nm to the blue fluorescent light emission layer of the blue fluorescent light emission unit 3A, a change in blue light peak intensity at the time of heating and applying current can be suppressed, and a decrease in device lifetime can be suppressed.

The following can be seen from Table 2 and Fig. 4 (change in correlated color temperature at the time of heating and applying current in Example 1), Fig. 7 (change in correlated color temperature at the time of heating and applying current in Example 2), Fig. 10 (change in correlated color temperature at the time of heating and applying current in Example 3), and Fig. 17 (change in correlated color temperature at the time of heating and applying current in Comparative Example 1).

By adding 0.6 wt% of a phosphorescent material having a maximum light emission wavelength of 450 nm to 650 nm to the blue fluorescent light emission layer of the blue fluorescent light emission unit 3A, it is possible to suppress a change in correlated color temperature at the time of heating and applying current and to suppress a decrease in device lifetime.

The following can be seen from Table 1 and Fig. 2 (total light flux spectrum of Example 1), Fig. 8 (total light flux spectrum of Example 3), Fig. 11 (total light flux spectrum of Example 4), Fig. 12 (total light flux spectrum of Example 5), Fig. 13 (total light flux spectrum of Example 6), and Fig. 14 (total light flux spectrum of Example 7).

By adding 0.2 wt% to 0.6 wt% of a phosphorescent material having maximum light emission wavelengths of 450 nm to 500 nm and 600 nm to 650 nm to the blue fluorescent light emission layer of the blue fluorescent light emission unit 3A, the blue light peak intensity around 460 nm can be controlled.

Note that, since the blue light peak intensity around 460 nm could be controlled also in the above results and Example 2 illustrated in Fig. 5, it is estimated that the blue light peak intensity around 460 nm can be controlled similarly even in a case where 0.2 wt% to 0.6 wt% of a phosphorescent material of 500 nm to 600 nm is added.

As described above, in the organic EL lighting devices of Examples 1 to 3 of the present invention, it was possible to suppress a change in blue light peak intensity and a change in color temperature due to heating and applying current for 300 hours while suppressing the blue light peak intensity to 18 to 28% with respect to the organic EL lighting device of Comparative Example 1, and it was possible to suppress a decrease in device lifetime.

Furthermore, in the organic EL lighting devices of Examples 1 to 7 of the present invention, the blue light peak intensity could be controlled only by adjusting the addition amount of the phosphorescent material without changing the film thickness.

### EXPLANATION OF REFERENCE SIGNS

1: substrate
2: anode
3A: blue fluorescent light emission unit
3B: green and red phosphorescent light emission unit
3C: charge generating layer
4: cathode
10: organic EL lighting device
25: organic EL device
32: blue fluorescent light emission layer

## Claims

1. An organic EL lighting device comprising an organic EL device including a substrate, an anode, a blue fluorescent light emission unit, a green and red phosphorescent light emission unit, and a cathode,
wherein in the organic EL device, a blue fluorescent light emission layer of the blue fluorescent light emission unit includes a fluorescent light emission host material and a phosphorescent material.

2. The organic EL lighting device according to claim 1, wherein the phosphorescent material has a maximum light emission wavelength of 450 nm to 650 nm.

3. The organic EL lighting device according to claim 1 or 2, wherein an amount of the phosphorescent material in the blue fluorescent light emission layer is 0.3 wt% or more.

4. The organic EL lighting device according to claim 1 or 2, further comprising a charge generating layer between the blue fluorescent light emission unit and the green and red phosphorescent light emission unit,
wherein an amount of the phosphorescent material in the blue fluorescent light emission layer is 0.1 wt% or more and less than 0.3 wt%.

5. The organic EL lighting device according to claim 1, wherein
the organic EL lighting device emits white light having a Melanopic Ratio value of 0.5 or less, and
the white light has a color temperature of 2000 K to 3000 K, a duv from a black-body radiation curve of 0.02 or less, and color reproducibility of 80 or more.

6. The organic EL lighting device according to claim 1, wherein an energy level of a triplet excited state of the fluorescent light emission host material of the blue fluorescent light emission layer is deeper than an energy level of a triplet excited state of the phosphorescent material.

7. The organic EL lighting device according to claim 1, further comprising: the organic EL device; and a blue light source,
wherein the blue light source is capable of emitting blue light that complements irradiation light of the organic EL device.

8. The organic EL lighting device according to claim 7, wherein the blue light source includes a blue OLED or a blue LED.
